# DEMANDE DE BREVET EUROPEEN

(11) **EP 2 391 191 A1**
(43) Date de publication de la demande: **30.11.2011**
(21) Numéro de dépôt: 10164333.6
(22) Date de dépôt: 28.05.2010
(51) Int. Cl.: H05K 1/02, H05K 1/11

(54) **Dispositif d'interconnexion pour circuits électroniques, notamment des circuits électroniques hyperfréquence**

(71) Demandeur: Thales, 92200 Neuilly Sur Seine (FR)
(72) Inventeur: Denis, Stéphane, 35340 La Bouexiere (FR); Cazenave, Jean-Pierre, 35000 Rennes (FR); Haquet, Gérard, 35220 Chateaubourg (FR)
(74) Mandataire: Lucas, Laurent Jacques

(57) **Abrégé**

Dispositif d'interconnexion (100) de circuits électroniques, notamment de circuits électroniques hyperfréquence, caractérisé en ce qu'il comprend au moins une ligne de transmission (103) couplée à une ligne de masse (104), les deux lignes (103, 104) étant réalisées sur une face d'un substrat diélectrique (101), au moins une surface de métallisation formant sur l'autre face du substrat diélectrique (101) au moins un élément de couplage (102) disposé sur une surface sensiblement égale à la surface occupée par la ligne de transmission (103) et la ligne de masse (104), l'interconnexion se réalisant sensiblement au niveau des extrémités de la ligne de transmission (103) et de la ligne de masse (104).

## Description

La présente invention concerne un dispositif d'interconnexion pour circuits électroniques, notamment des circuits électroniques hyperfréquence. Elle s'applique notamment aux liaisons électroniques entre différents circuits électroniques.

La présente invention concerne des applications pour lesquelles des liaisons électriques sont requises, entre différents circuits électroniques. Pour la suite, la notion de circuit électronique est à comprendre dans son acception la plus large, c'est-à-dire qu'un circuit électronique peut se présenter sous la forme d'un module électronique, par exemple d'une puce, d'un micro-système électro-mécanique, habituellement désigné sous l'acronyme de "MEMS", pour l'expression anglo-saxonne de "Micro-Electro-Mechanical System", d'un circuit intégré en boîtier, d'un module de cartes imprimées simples ou empilées, d'un module tridimensionnel, etc. Ces liaisons peuvent relier électriquement des circuits électroniques physiquement homogènes : par exemple des puces entre elles, ou bien des circuits électroniques physiquement hétérogènes, lorsqu'il s'agit par exemple de relier électriquement une puce à un support d'interconnexion avec un substrat, une carte imprimée, un boîtier, etc. Les signaux considérés peuvent être de caractère numérique rapide ou bien analogique hyperfréquence.

Plus particulièrement, la présente invention se rapporte à des applications dans lesquelles les liaisons électriques précitées sont destinées à la transmission de signaux électriques occupant une large bande de fréquences, et/ou qui se situent dans des fréquences élevées en regard des dimensions des liaisons à réaliser, et/ou qui présentent des puissances élevées. Il est par exemple considéré que des fréquences élevées en regard des dimensions des liaisons à réaliser, répondent à l'inégalité II>3.10⁹/1000.f, Il représentant la longueur de liaison en mètres, et f la fréquence du signal transmis, en Hertz.

Lorsque cette inégalité n'est pas satisfaite, la liaison réalisée est d'autant plus difficile à compenser que l'impédance caractéristique des interfaces est faible, que le niveau d'adaptation requis est élevé, et que la bande de fréquences d'intérêt est large.

Dans le but de limiter l'influence parasite des éléments de liaison, réalisés par exemple sous la forme de fils ou de rubans, les circuits électroniques qui doivent être reliées électriquement sont placées à la plus grande proximité possible les uns des autres. En conséquence, les dimensions et les tolérances qui y sont associées et qui sont associées au positionnement des éléments, sont réduites, au détriment des coûts de réalisation et des rendements de fabrication.

Cet inconvénient est d'autant plus critique que les assemblages considérés sont complexes et que de longues chaînes de dimensions sont impliquées. Par exemple, dans un cas relativement simple où des puces ou des modules de puissance sont montés sur des dissipateurs thermiques, au travers de cavités réalisées dans un substrat, une chaîne de dimensions peut être définie comme la somme de la distance de la plage de connexion sur le substrat par rapport au bord du substrat, de la distance du bord du substrat au bord de la puce ou du module, et de la distance du bord de la puce ou du module, à la plage de connexion sur la puce ou le module. Une tolérance fine associée à une telle chaîne de dimensions est réalisable en pratique, mais au prix de procédés de fabrication et de contrôle nécessairement coûteux, et au risque d'un rendement faible.

Il existe des solutions connues de l'état de la technique, mises en oeuvre pour limiter l'influence des phénomènes parasites ou la désadaptation des connexions.

Une première technique connue consiste à utiliser des broches de connexion, dont les formes peuvent être diverses. Ces broches de connexion peuvent par exemple être des pointes traversantes, des lyres, ou encore des broches plates montées en surface de circuits imprimés. Un inconvénient de cette technique est qu'elle n'est pas efficace pour la transmission de signaux à haute fréquence, et pour la dissipation de fortes puissances.

Une deuxième technique connue consiste à utiliser un micro-câblage comprenant une pluralité de fils conducteurs en parallèle, habituellement deux fils. Une telle technique est cependant souvent limitée par la surface disponible sur les plages de connexion, dont la surface est limitée par la fréquence des signaux à transmettre. Elle est également limitée par le phénomène d'inductance mutuelle entre les fils conducteurs.

Une troisième technique connue consiste à utiliser un micro-câblage comprenant des micro-rubans. Cette technique présente cependant également l'inconvénient d'être limitée par la surface disponible sur les plages de connexion, dont la surface est limitée par la fréquence des signaux à transmettre. Un autre inconvénient de cette technique est qu'elle est nettement plus coûteuse à mettre en oeuvre de manière industrielle, en comparaison avec la deuxième technique filaire précitée.

Une quatrième technique connue consiste à utiliser des micro-billes conductrices, brasées entre des plages métallisées de modules montés retournés les uns par rapport aux autres. Cette technique est connue sous le nom de technique de "puce retournée", et plus habituellement désignée selon la terminologie anglo-saxonne "flip-chip". Par exemple, une puce électronique ou un module équipé d'une matrice de billes conductrices - souvent désignée selon le sigle BGA, de l'expression anglo-saxonne "Ball Grid Array" - monté retourné sur un substrat. Cette technique est avantageuse pour des liaisons à très haute fréquence, et/ou à très large bande de fréquences. Cependant, cette technique est coûteuse à mettre en oeuvre de manière industrielle, et requiert des étapes supplémentaires dans le procédé de fabrication des dispositifs les mettant en oeuvre. En outre, cette technique présente l'inconvénient de ne pas être efficace en terme de dissipation thermique, lorsqu'elle est appliquée à des circuits électroniques monolithiques, de type puces. Elle peut s'avérer efficace lorsqu'elle est appliquée à des modules intégrant un dissipateur thermique, mais dans de tels cas la technique s'avère globalement très coûteuse à mettre en oeuvre de manière industrielle. Cette technique présente également l'inconvénient de nécessiter des puces ou des modules conçus spécifiquement pour ce type d'assemblages. Elle présente enfin un inconvénient lié à la difficulté, voire l'impossibilité, de réaliser des contrôles visuels sur les liaisons après assemblage.

Une cinquième technique connue consiste à utiliser des micro-plages de connexion, assemblées directement par brasure ou par collage sur des circuits électroniques montés retournés l'une par rapport à l'autre. Cette technique est similaire à la quatrième technique connue utilisant des micro-billes, décrite ci-dessus. Par exemple, une puce électronique ou un module équipé d'une matrice de micro-plages métallisées de connexion - souvent désignée selon le sigle LGA, de l'expression anglo-saxonne "Land Grid Array" - monté retourné sur un substrat. Cette technique permet également de réaliser des liaisons à très haute fréquence et/ou très large bande. En revanche, cette technique n'est pas efficace pour assurer l'adaptation des différences de coefficients de dilatation entre les différents circuits électroniques. D'une manière similaire à la quatrième technique décrite ci-dessus, cette technique présente l'inconvénient de ne pas être efficace en terme de dissipation thermique, lorsqu'elle est appliquée à des circuits électroniques monolithiques, de type puces. Elle peut également s'avérer efficace lorsqu'elle est appliquée à des modules intégrant un dissipateur thermique, mais au prix d'une mise en oeuvre très coûteuse. Cette technique présente également l'inconvénient de nécessiter des puces ou des modules conçus spécifiquement pour ce type d'assemblages. Elle présente également un inconvénient lié à la difficulté, voire l'impossibilité, de réaliser des contrôles visuels des liaisons après assemblage, même lorsque certaines liaisons sont réalisées avec des plages qui remontent sur les côtés, par exemple pour des modules munis de castellations, selon des techniques spécifiques au LGA.

Une sixième technique connue consiste à utiliser des micro-plots de connexion destinés à la réalisation de liaisons par thermo-compression ou par collage. Cette technique permet la réalisation de liaisons à très haute fréquence et/ou à très large bande de fréquences. Cependant, cette technique ne permet pas d'assurer une dissipation thermique efficace. Elle présente également un inconvénient lié à la difficulté, voire l'impossibilité, de réaliser des contrôles visuels des liaisons après assemblage.

Une septième technique connue consiste en un collage automatique par bande, cette technique est habituellement désignée selon l'acronyme "TAB", pour l'expression anglo-saxonne de "Tape Automated Bonding". Cette technique se base sur un circuit électrique réalisé sur un substrat fin et souple, dont les pistes dépassent et sont directement micro-câblées sur les plots d'interconnexion des éléments à relier, par exemple par thermo-compression ou par brasure collective. Cette technique permet un mode de liaison collectif, c'est-à-dire que toutes les opérations de connexion pour un même circuit imprimé, peuvent être réalisées de manière simultanée. La technique TAB permet par exemple la réalisation de liaisons avec des lignes de transmission coplanaires, de type masse / signal / masse. De telles lignes présentent l'inconvénient d'être sensibles aux dissymétries, de nécessiter un minimum de six points de contact par liaison, de nécessiter des plans de masse de large surface, ainsi qu'une grande finesse dans la réalisation de la ligne centrale, en termes de largeur de piste et d'écart avec les lignes de masse, dans le but d'obtenir des impédances caractéristiques typiques de l'ordre de 50 Ω.

Un but de la présente invention est de pallier les inconvénients propres aux dispositifs connus précités, en proposant un dispositif d'interconnexion pour circuits électroniques hyperfréquence, pouvant se substituer aux techniques connues d'interconnexion, le plus souvent filaires, ou également aux lignes de transmission coplanaires de type masse / signal / masse utilisées pour la réalisation de liaisons selon des techniques de type TAB. Un dispositif d'interconnexion selon l'invention permet la transmission de signaux électriques occupant une large bande de fréquences et/ou se situant à des fréquences élevées en regard des dimensions à réaliser et/ou présentant des puissances élevées, avec un niveau d'adaptation élevé.

La présente invention propose de relier électriquement les circuits électroniques avec un élément formant une ligne de transmission de longueur et d'impédance caractéristique appropriées. Cette approche est différente des approches connues de liaisons filaires qui sont plutôt de caractère localisé, alors qu'une ligne de transmission est de caractère distribué. Cette ligne de transmission présente une impédance caractéristique et un mode de propagation très proches de ceux qui sont présentés aux interfaces des circuits électroniques à relier.

Du fait que le dispositif d'interconnexion selon les divers modes de réalisation de l'invention forme une ligne de transmission, les performances - par exemple les pertes d'insertion et d'adaptation - de la liaison électrique dépendent peu de sa longueur, jusqu'à la fréquence de coupure de la liaison, qui résulte d'une résonance parasite. Tel n'est pas le cas avec des liaisons connues utilisant des fils ou des rubans.

Un avantage de l'invention est de permettre la réalisation de liaisons électriques de type ligne à transmission, dont les dimensions permettent de relâcher les éléments d'une chaîne de dimensions, et d'éloigner les plages de connexion.

Un autre avantage de l'invention est qu'elle permet de réaliser des dispositifs d'interconnexion dont les dimensions sont plus réduites que des liaisons réalisées avec des lignes coplanaires du type masse / signal / masse, dont les assemblages sont de moindre complexité, et dont l'immunité vis-à-vis de phénomènes parasites est moindre.

Un autre avantage de l'invention est que le type de liaison électrique qu'elle propose supporte mieux, par rapport à des liaisons filaires, des puissances électriques élevées.

Encore un autre avantage de l'invention est que le type de liaison électrique qu'elle propose confine mieux les champs électromagnétiques, en comparaison à des liaisons filaires ou des liaisons par rubans de taille comparable. Cela permet de minimiser les couplages parasites entre des circuits électroniques disposés à proximité les uns des autres.

A cet effet, l'invention a pour objet un dispositif d'interconnexion de circuits électroniques, caractérisé en ce qu'il comprend au moins une ligne de transmission couplée à une ligne de masse, les deux lignes étant réalisées sur une face d'un substrat diélectrique, au moins une surface de métallisation formant sur l'autre face du substrat diélectrique au moins un élément de couplage pour le renforcement du couplage électrique entre les deux lignes, ledit élément de couplage étant disposé sur une surface sensiblement égale à la surface occupée par la ligne de transmission et la ligne de masse, l'interconnexion étant réalisée sensiblement au niveau des extrémités de la ligne de transmission et de la ligne de masse.

Dans un mode de réalisation de l'invention, des plages de connexion sont réalisées aux extrémités de la ligne de transmission et de la ligne de masse.

Dans un mode de réalisation de l'invention, des plots de connexion sont réalisés aux extrémités de la ligne de transmission et de la ligne de masse.

Dans un mode de réalisation de l'invention, le dispositif d'interconnexion peut être caractérisé en ce qu'une pluralité d'éléments de couplage est formée par une pluralité de surfaces de métallisation de formes identiques et disposées de manière sensiblement périodique à une distance déterminée les unes des autres.

Dans un mode de réalisation de l'invention, le dispositif d'interconnexion peut être caractérisé en ce que la ligne de transmission et la ligne de masse sont sensiblement de mêmes dimensions et disposées parallèlement.

Dans un mode de réalisation de l'invention, le dispositif d'interconnexion peut être caractérisé en ce que la ligne de masse est reliée au niveau de sa partie centrale, à un double tronçon de ligne augmentant la fréquence de coupure haute du dispositif d'interconnexion.

Dans un mode de réalisation de l'invention, le dispositif d'interconnexion peut être caractérisé en ce que le double tronçon de ligne présente sensiblement une forme de "T" dont la branche verticale est reliée au niveau de la partie centrale de la ligne de masse, les branches horizontales s'étendant parallèlement à la ligne de masse sur une longueur au moins égale à la longueur de la ligne de masse, les extrémités distales des branches horizontales étant prolongées par une surface s'étendant perpendiculairement à celles-ci.

Dans un mode de réalisation de l'invention, le dispositif d'interconnexion peut être caractérisé en ce qu'une première ligne de transmission est disposée parallèlement à la ligne de masse disposée parallèlement à une deuxième ligne de transmission, les trois lignes formant un système de type signal / masse / signal.

Dans un mode de réalisation de l'invention, le dispositif d'interconnexion peut être caractérisé en ce que les éléments de couplage sont reliés électriquement à la ligne de masse par des via conducteurs traversant le substrat diélectrique.

Dans un mode de réalisation de l'invention, le dispositif d'interconnexion peut être caractérisé en ce qu'une pluralité de liaisons électriques formées chacune par au moins une ligne de transmission et une ligne de masse sont réalisées sur le substrat diélectrique.

Dans un mode de réalisation de l'invention, le dispositif d'interconnexion peut être caractérisé en ce que le substrat diélectrique est réalisé dans un matériau souple.

Dans un mode de réalisation de l'invention, le dispositif d'interconnexion peut être caractérisé en ce que le matériau souple est une résine de type polytetrafluoréthylène chargée de céramique sur fibre de verre tissée, ou bien une résine époxy sur verre tissé, ou tout autre matière souple organique.

Dans un mode de réalisation de l'invention, le dispositif d'interconnexion peut être caractérisé en ce que les lignes sont réalisées par une technique de collage automatique par bande de type TAB.

D'autres caractéristiques et avantages de l'invention apparaîtront à la lecture de la description, donnée à titre d'exemple, faite en regard des dessins annexés qui représentent :
- la figure 1, une vue en perspective d'un dispositif d'interconnexion selon un exemple de mode de réalisation de la présente invention, reliant deux modules électroniques ;
- la figure 2, une vue en perspective illustrant le détail des deux modules électroniques reliés électriquement par un dispositif d'interconnexion selon un exemple de mode de réalisation de l'invention ;
- les figure 3a et 3b, des vues en perspective illustrant le détail respectivement du dessous et du dessus d'un dispositif d'interconnexion selon un exemple de mode de réalisation de la présente invention ;
- les figures 4a et 4b, des vues en perspective illustrant le détail respectivement du dessous et du dessus d'un dispositif d'interconnexion selon un exemple alternatif de mode de réalisation de la présente invention ;
- les figures 5a et 5b, des exemples de courbes de comportement fréquentiel de dispositifs d'interconnexion selon deux exemples de modes de réalisation de la présente invention.

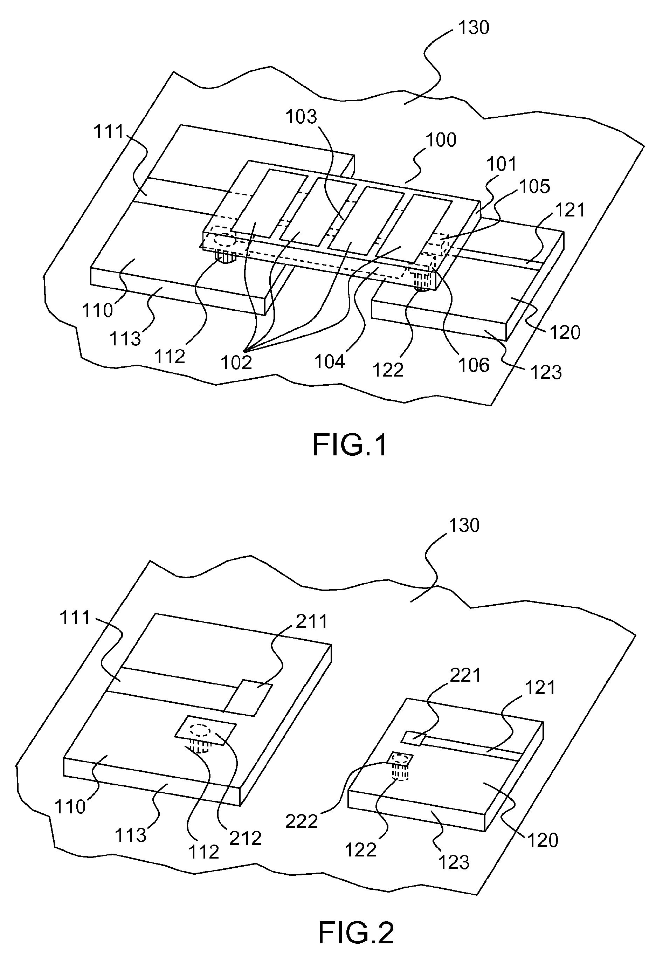

La figure 1 présente une vue en perspective d'un dispositif d'interconnexion selon un exemple de mode de réalisation de la présente invention, reliant deux modules électroniques.

Un dispositif d'interconnexion 100 comprenant un substrat diélectrique 101, relie électriquement un premier module électronique 110 à un second module électronique 120. Dans l'exemple de la figure, les deux modules électroniques 110, 120 reposent sur un support conducteur 130. Le premier module électronique 110 comprend un premier substrat diélectrique 113. Le second module électronique 120 comprend un second substrat diélectrique 123. Le premier module électronique 110 est terminé, sur la surface supérieure du premier substrat diélectrique 113, par l'extrémité d'une première ligne de transmission 111 de type micro-ruban. Le second module électronique 120 est terminé, sur la surface supérieure du second substrat diélectrique 123, par l'extrémité d'une seconde ligne de transmission 121 de type micro-ruban.

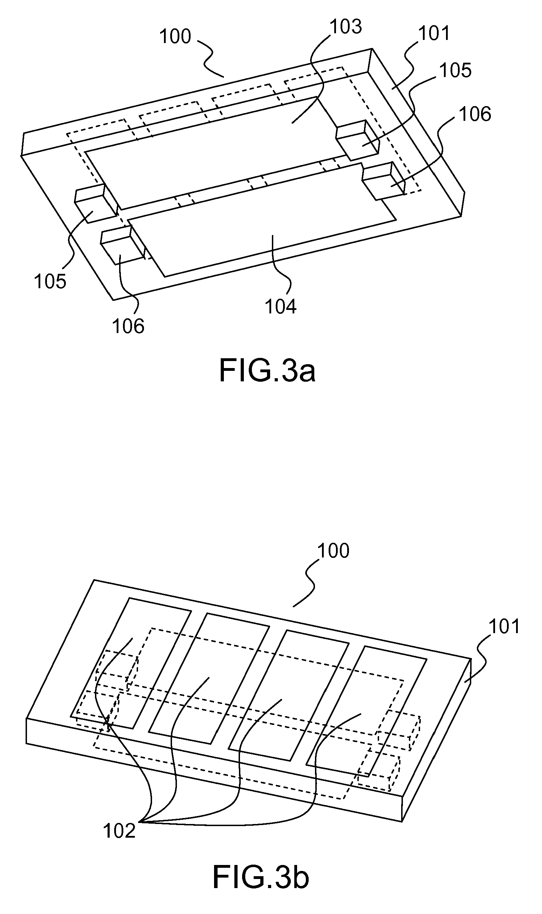

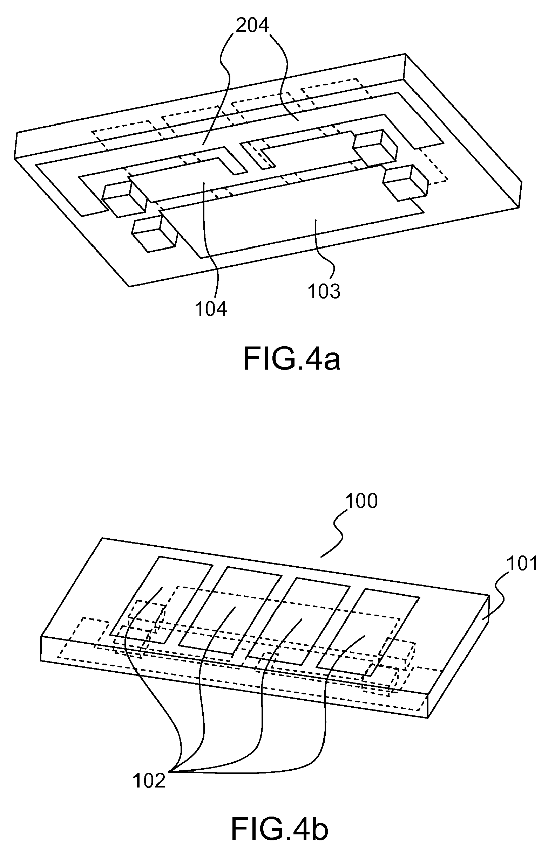

Le dispositif d'interconnexion 100 comprend sur sa face inférieure, une ligne de transmission 103 conductrice, disposée en parallèle, et couplée avec une ligne de masse 104. Le dispositif d'interconnexion 100 comprend sur la face supérieure du substrat diélectrique 101, une pluralité d'éléments de couplage 102. La ligne de transmission 103 comprend à ses deux extrémités, des plots de connexion 105. La ligne de masse 104 comprend également à ses deux extrémités, des plots de connexion 106. Dans l'exemple de la figure, des via conducteurs 112 et 122 traversant respectivement les premier et second substrats diélectriques 113, 123, relient électriquement le support conducteur 130 à deux plages de connexion non représentées sur la figure, et elles-mêmes reliées aux plots de connexion 106 situés aux extrémités de la ligne de masse 104 du dispositif d'interconnexion 100. Les structures des deux modules électroniques 110, 120 sont décrites en détails ci-après en référence à la figure 2. Le dispositif d'interconnexion 100 est décrit ci-après selon différents exemples de modes de réalisation de l'invention, en référence aux figures 3 et 4.

Il est à observer que l'exemple illustré par la figure 1 présente des plots de connexion 105, 106 réalisés aux extrémités de la ligne de transmission 103 et de la ligne de masse 104. Il est également possible de former des plages de connexion aux extrémités des lignes de transmission et de masse 103, 104, par exemple par un élargissement de la surface de métallisation ; il est également possible de réaliser l'interconnexion directement, sensiblement au niveau des extrémités des lignes de transmission et de masse 103, 104, sans que des plots ni des plages n'y aient été formées à cette fin. Il est également possible de combiner ces différents modes de réalisation, afin d'adapter au mieux le dispositif d'interconnexion à l'application à laquelle il se destine.

L'exemple de la figure présente des modules électroniques 110, 120. Il est à observer que le terme de module électronique doit être compris dans son acception la plus large. Il est possible de substituer les modules électroniques 110, 120 par des puces électroniques, des modules tridimensionnels, des composants de type MEMS, ou encore des micro-systèmes opto-électro-mécaniques, habituellement désignés selon l'acronyme MOEMS pour la terminologie anglo-saxonne de "Micro Opto-Electro-Mechanical System". De la même manière, les modules électroniques 110, 120 comprennent dans l'exemple de la figure des lignes de transmission de type micro-ruban, mais ils peuvent également comprendre tout autre type connu de liaison électrique de type filaire, ou bien de type ligne à transmission.

La figure 2 présente une vue en perspective illustrant le détail des deux modules électroniques reliés électriquement par un dispositif d'interconnexion selon un exemple de mode de réalisation de l'invention.

La première ligne de transmission 111, réalisée sur la surface supérieure du premier substrat diélectrique 113 du premier module électronique 110, est terminée par une plage de connexion 211 de la ligne de transmission. Le premier via conducteur 112 relie électriquement le support conducteur 130 à une plage de connexion 212 de la masse.

De la même manière, la seconde ligne de transmission 121, réalisée sur la surface supérieure du second substrat diélectrique 123 du second module électronique 120, est terminée par une plage de connexion 221 de la ligne de transmission. Le second via conducteur 122 relie électriquement le support conducteur 130 à une plage de connexion 222 de la masse.

Par exemple, le premier substrat 113 du premier module électronique 110 peut être réalisé en céramique, et le second substrat 123 du second module électronique 120 peut être réalisé dans un matériau à base de résine hydrocarbonée. Les constantes diélectriques de ces matériaux étant différentes, il est ainsi possible que les épaisseurs des substrats 113 et 123 soient différentes. Un dispositif d'interconnexion selon un des modes de réalisation de l'invention permet néanmoins la liaison entre des éléments dont les hauteurs sont différentes, par un choix approprié de la forme des plots de connexion ou du mode de fixation de ceux-ci sur les plages de connexion 211, 212, 221, 222. Il est en effet possible d'utiliser des modes de fixation différents pour la fixation des plots de connexion du dispositif d'interconnexion sur le premier module électronique 110 et le second module électronique 120 : par exemple utiliser des micro-billes pour la fixation du module le moins épais, et un mode de fixation par collage pour le module le plus épais.

Les figures 3a et 3b présentent des vues en perspective illustrant le détail respectivement du dessous et du dessus d'un dispositif d'interconnexion selon un exemple de mode de réalisation de la présente invention.

Dans cet exemple de mode de réalisation illustré par les figures 3a et 3b, dans un premier temps en référence à la figure 3a, le dispositif d'interconnexion 100 comporte sur la face inférieure du substrat 101, la ligne de transmission 103 et la ligne de masse 104, formées dans le même plan par des surfaces de métallisation. Dans l'exemple de la figure, les deux lignes 103, 104 sont disposées parallèlement et ont les mêmes dimensions. Elles sont toutes deux terminées de part et d'autre par les plots de connexion 105, 106, qui peuvent être formées par de simples surfaces de métallisation, ou bien par exemple par des métallisations de plus grande épaisseur, ou bien encore par la fixation de micro-billes sur des surfaces de métallisation. Il est également possible que les connexions avec des circuits électroniques soient réalisées directement par un contact avec les extrémités des lignes 103, 104, sans que des plots de connexion ne soient véritablement présents. Les dimensions typiques du dispositif d'interconnexion peuvent être une longueur de l'ordre du millimètre, et une épaisseur de l'ordre de quelques dizaines de micromètres selon la nature du substrat diélectrique 101, pour la transmission de signaux pouvant atteindre une fréquence de l'ordre de 150 GHz. Il n'est pas possible de réaliser des liaisons efficaces utilisant des fils ou des micro-rubans, permettant la transmission de signaux dont la fréquence est si élevée, sur une longueur aussi grande.

Le matériau utilisé pour le substrat diélectrique 101 peut par exemple être un matériau souple, tel qu'une résine de type polytetrafluoréthylène, habituellement désignée selon le sigle PTFE chargée de céramique sur fibre de verre tissée, ou bien une résine époxy sur verre tissé, ou toute autre matière souple organique. La souplesse du substrat diélectrique 101 permet une meilleure tolérance des contraintes thermomécaniques, induite notamment par les différences de propriétés dilatatoires des divers éléments métalliques. Elle permet aussi une meilleure tolérance des contraintes vibratoires induites par l'environnement dans lequel le dispositif d'interconnexion 100 se situe.

En référence à la figure 3b, le dispositif d'interconnexion 100 comporte, sur la face supérieure du substrat diélectrique 101, une pluralité d'éléments de couplage 102, formés par des métallisations, couvrant une surface sensiblement égale à la surface des lignes 103, 104 situées sur l'autre face du substrat diélectrique 101. Les éléments de couplage 102 permettent un meilleur couplage de la ligne de transmission 103 avec la ligne de masse 104. Le couplage électromagnétique est ainsi renforcé, tout en autorisant un éloignement relatif des deux lignes. Il peut être envisagé de former un unique élément de couplage par une même surface de métallisation ; cependant il est avantageux de recourir à une pluralité d'éléments de couplage 102 : cela permet de ne pas générer de résonances indésirables dans la bande de fréquences utile. Les éléments de couplage 102 sont par exemple disposés à une distance déterminée les uns des autres, et de manière périodique. Il est avantageux, pour de meilleures performances, que la distance séparant les éléments de couplage 102 soit la plus faible possible, en regard de la technique de fabrication utilisée.

Les deux lignes parallèles couplées 103, 104, sont réalisées de façon à offrir une impédance caractéristique standard, par exemple une impédance typique en hyperfréquences de 50 Ω ou 75 Ω. Il peut être envisagé de ne pas recourir à des éléments de couplage 102 ; cependant, si par exemple des procédés de fabrication peu coûteux sont employés, tels que des procédé par gravure chimique, alors l'écart minimum réalisable entre la ligne de transmission 103 et la ligne de masse 104 est trop important pour assurer un couplage satisfaisant. Les éléments de couplage 102 permettent ainsi de renforcer le couplage électrique ; en outre les éléments de couplage 102 permettent d'ajuster l'impédance caractéristique du mode fondamental, ou mode dit quasi-transverse électromagnétique ou encore quasi-TEM, c'est-à-dire dans lequel la composante longitudinale des champs électrique et magnétique est considérée comme négligeable, propagé sur les deux lignes 103, 104 parallèles couplées.

Les figures 4a et 4b présentent des vues en perspective illustrant le détail respectivement du dessous et du dessus d'un dispositif d'interconnexion selon un exemple alternatif de mode de réalisation de la présente invention.

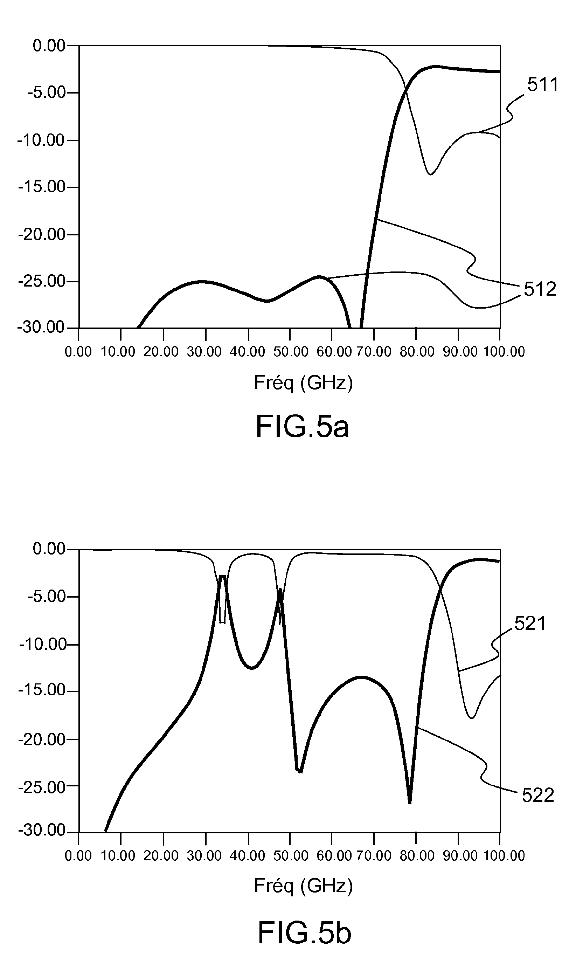

D'une manière similaire au mode de réalisation décrit précédemment en référence aux figures 3a et 3b, dans un premier temps en référence à la figure 4a, le dispositif d'interconnexion 100 comporte sur la face inférieure du substrat 101, la ligne de transmission 103 et la ligne de masse 104, formées dans le même plan par des surfaces de métallisation. Dans cet exemple de mode de réalisation, les deux lignes 103, 104 ne sont pas identiques. En effet, la ligne de masse 104 est reliée, au niveau de sa partie centrale, à un double tronçon de ligne 204, qu'il est également possible de désigner "double stub" selon la terminologie anglo-saxonne habituellement utilisée dans le domaine technique de la présente invention. Le double tronçon de ligne 204 a une influence sur les phénomènes de résonance parasite, et permet de déplacer vers des fréquences plus élevées la fréquence de coupure haute du dispositif d'interconnexion 100, élargissant d'autant la bande passante de ce dernier. La présence du double tronçon de ligne 204 introduit néanmoins des fréquences de coupure basses. En donnant une forme particulière au double tronçon de ligne 204, il est possible de déplacer vers les basses fréquences, la fréquence de coupure basse la plus élevée, et conférer ainsi au dispositif d'interconnexion 100 une plus large bande de fréquences, notamment dans les fréquences les plus élevées. Par exemple, le tronçon de ligne 204 peut être relié à la ligne de masse 104 au milieu de celle-ci, et comprendre une surface ayant la forme d'un "T", dont les branches horizontales s'étendent sensiblement parallèlement à la ligne de masse 104, sur toute sa longueur et au-delà. Les branches horizontales du "T" formé par le tronçon de ligne 204 peuvent alors, au niveau de leurs extrémités distales, être prolongées par une surface s'étendant perpendiculairement à celles-ci. Le comportement fréquentiel des structures décrites ci-dessus en référence aux figures 3a, 3b, 4a et 4b, est décrit en de plus amples détails ci-après en référence aux figures 5a et 5b.

D'une manière similaire au mode de réalisation précédent, en référence à la figure 4b, le dispositif d'interconnexion 100 comporte, sur la face supérieure du substrat diélectrique 101, une pluralité d'éléments de couplage 102, formés par des métallisations, couvrant une surface sensiblement égale à la surface des lignes 103, 104 situées sur l'autre face du substrat diélectrique 101.

Il est à observer que les liaisons électriques réalisées par un dispositif d'interconnexion selon l'un quelconque des modes de réalisation de la présente invention décrits ci-dessus, est une liaison de type mono-mode, contrairement à des liaisons électriques réalisées par 3 lignes coplanaires de type masse/signal/masse. En conséquence la liaison électrique réalisée par un dispositif d'interconnexion selon l'un quelconque des modes de réalisation de l'invention est peu sensible aux asymétries. Néanmoins, il est avantageusement possible d'envisager un mode alternatif de réalisation de l'invention, s'appliquant à la transmission de signaux différentiels, en réalisant, plutôt qu'une ligne de transmission 103 et une ligne de masse 104, trois lignes : une ligne de transmission d'un premier signal, une ligne centrale de masse, et une deuxième ligne de transmission d'un second signal.

Il est également à noter qu'une liaison électrique de type coplanaire à deux lignes, telle que présentée dans les modes de réalisation de l'invention décrits ci-dessus, présente de nombreux avantages par rapport à une liaison électrique coplanaire connue de type masse / signal / masse. Notamment :
- une liaison électrique de type coplanaire à deux lignes est plus simple à mettre en oeuvre car elle nécessite un minimum de quatre points d'attache au lieu de six ;
- l'encombrement d'une liaison électrique de type coplanaire à deux lignes est moindre, car les deux lignes de masse larges habituellement présente dans une liaison électrique coplanaire connue de type masse / signal / masse, sont substituées par une seule ligne de masse de largeur moindre ;

- une liaison électrique de type coplanaire à deux lignes présente une sensibilité moindre aux asymétries de fabrication et de montage qui engendrent des dégradations de la liaison. Sur les lignes coplanaires à trois conducteurs, de telles dégradations résultent des couplages des modes de propagation pair et impair ;
- l'utilisation d'une liaison électrique de type coplanaire à deux lignes réduit la précision de réalisation nécessaire au niveau de l'écartement des lignes couplées, notamment grâce à la présence des éléments de couplage 102, qui permettent un renforcement du couplage entre les lignes 103, 104, ainsi que l'obtention d'une impédance caractéristique, par exemple de 50 Ω, avec des écarts de ligne plus larges. Avec une liaison électrique coplanaire connue de type masse / signal / masse, de tels avantages ne peuvent s'obtenir qu'au prix d'une liaison électrique des lignes de masse jusqu'à un plan de masse, en utilisant des via traversants dont la réalisation industrielle est coûteuse.

Les éléments de couplage 102 présents dans les exemples de modes de réalisation de l'invention décrits ci-dessus, forment une structure flottante. Il est cependant possible d'envisager de relier électriquement les éléments de couplage 102 à la ligne de masse 104 en employant des via traversants, dans le but de renforcer les performances de couplage et de réponse fréquentielle du dispositif d'interconnexion.

Avantageusement, il est possible de réaliser plusieurs liaisons électriques selon l'un quelconque des modes de réalisation de l'invention décrits ci-dessus, sur un même substrat. Un tel mode de réalisation peut par exemple être envisagé pour assurer avec un seul dispositif, la liaison électrique entre une pluralité de modules. La réalisation d'un tel dispositif peut par exemple être faite selon la technique TAB.

Bien sûr, les dispositifs d'interconnexion selon les modes de réalisation de l'invention décrits ci-dessus peuvent également s'appliquer à des interfaces de type ligne à fente ou lignes coplanaires masse / signal / masse, même si les exemples présentés s'appliquent à des interfaces de type liaison par ruban.

Les dispositifs d'interconnexion selon les modes de réalisation de l'invention décrits ci-dessus sont compatibles avec des moyens industriels de pose et de fixation automatique de composants utilisés en microélectronique. Les équipements de pose automatique sont généralement capables de garantir la précision requise pour le positionnement relatif des dispositifs d'interconnexion vis-à-vis des circuits électroniques qui doivent être électriquement reliées. De plus, les contraintes de positionnement peuvent avantageusement être relâchées en disposant d'un jeu de dispositifs d'interconnexion 100 de longueurs différentes, ce jeu couvrant la plage de variation des distances à couvrir.

Leur fixation sur deux circuits électroniques à relier peut se faire par l'intermédiaire de moyens en eux-mêmes connus, par exemple par des plots de colle conductrice, ou via des microbilles métalliques, ou par brasure, ou par thermo-sonie, thermo-compression, ou bien encore par une combinaison de ces procédés.

Les figures 5a et 5b présentent des exemples de courbes de comportement fréquentiel de dispositifs d'interconnexion selon deux exemples de modes de réalisation de la présente invention.

La figure 5a présente plus précisément le comportement fréquentiel d'un dispositif d'interconnexion tel que décrit en référence aux figures 3a et 3b. Un repère orthonormé représente en ordonnée l'atténuation en dB, en fonction de la fréquence du signal portée en abscisse. Une première courbe 511 représente l'atténuation de signaux transmis au travers de la liaison électrique formée par le dispositif d'interconnexion. La courbe 512 représente l'atténuation de signaux réfléchis par la liaison électrique formée par le dispositif d'interconnexion.

D'une manière similaire, la figure 5b présente plus précisément le comportement fréquentiel d'un dispositif d'interconnexion 100 tel que décrit en référence aux figures 4a et 4b. Une première courbe 521 représente l'atténuation de signaux transmis au travers de la liaison électrique formée par le dispositif d'interconnexion. La courbe 522 représente l'atténuation de signaux réfléchis par la liaison électrique formée par le dispositif d'interconnexion.

En référence à la figure 5a, le dispositif d'interconnexion 100 tel qu'illustré par les figures 3a et 3b permet une liaison électrique couvrant une large bande de fréquence, typiquement de 0 à 70GHz : les deux courbes de performances 511, 512 sont dans l'exemple de la figure issues d'une liaison dont la longueur - c'est-à-dire la distance séparant les deux extrémités des plots de connexion 105, 106, est de 800 µm.

En référence à la figure 5b, le dispositif d'interconnexion 100 tel que décrit en référence aux figures 4a et 4b permet une liaison électrique couvrant une bande de fréquence typiquement de l'ordre de l'octave, pour des fréquences inférieures à 100 GHz. Egalement, les deux courbes de performances 521, 522 sont dans l'exemple de la figure issues d'une liaison dont la longueur - c'est-à-dire la distance séparant les deux extrémités des plots de connexion 105, 106, est de 800 µm.

Bien sûr, les valeurs apparaissant sur les figures 5a et 5b sont données à titre d'exemple indicatif, et ne sont pas restrictives car il est possible d'obtenir une infinité de solutions en faisant varier les dimensions et les propriétés des matériaux utilisés dans le dispositif d'interconnexion.

Un dispositif d'interconnexion selon l'un quelconque des modes de réalisation décrits ci-dessus peut également être utilisé pour réaliser une transition entre des lignes coplanaires de type masse / signal / masse simples. Il peut également être utilisé pour réaliser des transitions entre de multiples lignes alternées masse / signal / masse / signal / masse, etc. Il peut être également utilisé pour réaliser des transitions multiples autour d'un circuit intégré monolithique micro-ondes, réalisées sur une même structure souple, c'est-à-dire sur un même substrat. Il peut également être utilisé pour réaliser un nouveau type de boîtier pour des circuits intégrés monolithiques hyperfréquences habituellement désignés par le sigle MMIC, ce nouveau type de boîtier étant concurrent aux boîtiers employant des techniques connues telles que le BGA ou le LGA précitées, et comprenant des transitions telles que mentionnées ci-dessus, directement intégrées sur la périphérie du boîtier.

La présente invention est particulièrement appropriée lorsqu'il est nécessaire par exemple de relier les entrées et sorties d'un amplificateur faible bruit refroidi à l'aide de micro-systèmes thermo-électriques ou autres systèmes de cryogénie, ces systèmes imposant des longueurs de liaisons électriques relativement importantes en regard des fréquences des signaux impliqués.

La présente invention est également particulièrement appropriée pour la réalisation d'amplificateurs de puissance en général, car les assemblages qui assurent la dissipation de la puissance compliquent la réalisation de courtes liaisons vers les entrées-sorties hyperfréquences. Si un soin particulier est apporté afin d'assurer une faible résistivité électrique et une forte section sur les conducteurs, alors les dispositifs d'interconnexion selon les divers modes de réalisation de l'invention sont particulièrement bien adaptés pour supporter des signaux électriques de forte puissance.

La présente invention est également particulièrement appropriée pour la réalisation d'amplificateurs de puissance à large bande de fréquences, souvent réalisés en technologie monolithique à base d'Arseniure de Gallium (AsGa), de Nitrure de Gallium (GaN), ou de Silicium-Germanium (SiGe).

La présente invention est également particulièrement appropriée pour la réalisation d'amplificateurs de moyenne puissance de très larges bande de fréquences, typiquement les amplificateurs distribués, en technologie InP (Phosphure d'Indium), qui sont utilisés dans les liaisons à ultra haut débit (40 Gb/s et plus) sur fibres optiques.

La présente invention est également très appropriée pour la réalisation de circuits MMIC (AsGa et SiGe) formant des puces de contrôle de phase et d'amplitude dans des modules d'antennes actives pour radars et surtout pour les dispositifs radar exigeant le traitement de signaux de très large bande.

La présente invention est également très appropriée pour la réalisation de récepteurs et émetteurs à ultra-large bande.

La présente invention est également particulièrement appropriée pour la réalisation de dispositifs microélectroniques requérant un conditionnement thermique à très basse température.

La présente invention est également particulièrement appropriée pour la réalisation d'amplificateurs de puissance à fort rendement (typiquement en classes C,E,D,F et F-Inversée, etc.), car bien que n'étant généralement pas larges bandes, ils nécessitent de maîtriser les impédances présentées aux deux premiers harmoniques.

La présente invention est également particulièrement appropriée pour la réalisation de composants microélectroniques tels que les MEMS ou MOEMS, sur lesquels les distances entre les plots de connexion et les bords de découpe du substrat sont habituellement très grandes.

Il est à noter que les applications principalement visées par la présente invention impliquent typiquement des fréquences de signaux se situant au-dessus de 30 GHz (bande K) et/ou à forte puissance, c'est à dire au-dessus de 3W. Il est cependant possible de trouver un intérêt analogue pour de tels dispositifs d'interconnexion, dans des applications impliquant des signaux de plus basse fréquence (par exemple en bande S), de très forte puissance et imposant un très faible coût de fabrication, et partant des substrats avec des règles de découpe très larges. Ce type d'applications se rencontre typiquement dans le cas d'amplificateurs de puissance réalisés en technologie GaN. En effet, cette technologie permet d'atteindre des densités de puissance très élevées (en W/mm² de substrat) avec des impédances caractéristiques plus élevées qu'en technologie AsGa. La technologie GaN favorise donc l'émergence de nouveaux amplificateurs de puissance monolithiques avec des densités de puissances de plus en plus élevées, qui sont adaptés sur des niveaux d'impédance standards (typiquement 50Ω), et qui nécessitent des solutions de dissipation de puissance efficaces. Dans ces cas, les dispositifs d'interconnexion selon les différents modes de réalisation de l'invention présentés, s'avèrent très efficaces pour libérer les contraintes de dimensions du système de refroidissement au niveau des puces.

Bien sûr, la structure d'un dispositif d'interconnexion selon l'un quelconque des modes de réalisation de l'invention présentés, peut être optimisée en fonction des applications visées. Cela est par exemple le cas pour des applications nécessitant des sorties sur basses impédances caractéristiques, pour des composants semi-conducteurs de très forte puissance. De telles applications supposent par exemple d'utiliser des via de façon à superposer les lignes et générer une impédance caractéristique de faible valeur. Il est également possible d'ajouter une fonction d'adaptation d'impédance à la liaison électrique, en ajoutant sur la ligne de transmission des éléments supplémentaires comme des condensateurs.

Un dispositif d'interconnexion selon l'un quelconque des modes de réalisation de l'invention peut être également optimisé de manière à ajuster la bande passante offerte, de façon à lui conférer une fonction supplémentaire de filtrage. Pour des applications de filtrage plus élaborées, il est également possible de lui adjoindre des résonateurs spécifiques.

## Revendications

1. Dispositif d'interconnexion (100) de circuits électroniques, **caractérisé en ce qu'**il comprend au moins une ligne de transmission (103) couplée à une ligne de masse (104), les deux lignes (103, 104) étant réalisées sur une face d'un substrat diélectrique (101), au moins une surface de métallisation formant sur l'autre face du substrat diélectrique (101) au moins un élément de couplage (102) pour le renforcement du couplage électrique entre les deux lignes (103, 104), ledit élément de couplage étant disposé sur une surface sensiblement égale à la surface occupée par la ligne de transmission (103) et la ligne de masse (104), l'interconnexion se réalisant sensiblement aux extrémités de la ligne de transmission (103) et de la ligne de masse (104).

2. Dispositif d'interconnexion (100) selon la revendication 1, **caractérisé en ce que** la ligne de transmission (103) et la ligne de masse (104) sont terminées à leurs extrémités par des plages de connexion.

3. Dispositif d'interconnexion (100) selon la revendication 1, **caractérisé en ce que** la ligne de transmission (103) et la ligne de masse (104) sont terminées à leurs extrémités par des plots de connexion (105, 106).

4. Dispositif d'interconnexion (100) selon la revendication 1, **caractérisé en ce qu'**une pluralité d'éléments de couplage (102) est formée par une pluralité de surfaces de métallisation de formes identiques et disposées de manière sensiblement périodique à une distance déterminée les unes des autres.

5. Dispositif d'interconnexion (100) selon l'une quelconque des revendications précédentes, **caractérisé en ce que** la ligne de transmission (103) et la ligne de masse (104) sont sensiblement de mêmes dimensions et disposées parallèlement.

6. Dispositif d'interconnexion (100) selon l'une quelconque des revendications 1 à 5, **caractérisé en ce que** la ligne de masse (104) est reliée au niveau de sa partie centrale, à un double tronçon de ligne (204) augmentant la fréquence de coupure haute du dispositif d'interconnexion (100).

7. Dispositif d'interconnexion (100) selon la revendication 6, **caractérisé en ce que** le double tronçon de ligne (204) présente sensiblement une forme de "T" dont la branche verticale est reliée au niveau de la partie centrale de la ligne de masse (104), les branches horizontales s'étendant parallèlement à la ligne de masse (104) sur une longueur au moins égale à la longueur de la ligne de masse (104), les extrémités distales des branches horizontales étant prolongées par une surface s'étendant perpendiculairement à celles-ci.

8. Dispositif d'interconnexion (100) selon l'une quelconque des revendications 1 à 4, **caractérisé en ce qu'**une première ligne de transmission (103) est disposée parallèlement à la ligne de masse (104) disposée parallèlement à une deuxième ligne de transmission (103), les trois lignes (103, 104) formant un système de type signal / masse / signal.

9. Dispositif d'interconnexion (100) selon l'une quelconque des revendications précédentes, **caractérisé en ce que** les éléments de couplage (102) sont reliés électriquement à la ligne de masse (104) par des via conducteurs traversant le substrat diélectrique (101).

10. Dispositif d'interconnexion (100) selon l'une quelconque des revendications précédentes, **caractérisé en ce qu'**une pluralité de liaisons électriques formées chacune par au moins une ligne de transmission (103) et une ligne de masse (104) sont réalisées sur le substrat diélectrique (101).

11. Dispositif d'interconnexion (100) selon l'une quelconque des revendications précédentes, **caractérisé en ce que** le substrat diélectrique (101) est réalisé dans un matériau souple.

12. Dispositif d'interconnexion (100) selon la revendication 10, **caractérisé en ce que** le matériau souple est une résine de type polytetrafluoréthylène chargée de céramique sur fibre de verre tissée, ou bien une résine époxy sur verre tissé, ou tout autre matière souple organique.

13. Dispositif d'interconnexion (100) selon l'une quelconque des revendications précédentes, **caractérisé en ce que** les lignes (103, 104) sont réalisées par une technique de collage automatique par bande de type TAB.
